# EUROPEAN PATENT APPLICATION

(11) **EP 2 698 836 A1**
(43) Date of publication of application: **19.02.2014**
(21) Application number: 12180925.5
(22) Date of filing: 17.08.2012
(51) Int. Cl.: H01L 51/52, H05K 3/20, H05K 1/16, H01L 27/32, H05K 1/02, H05K 1/03

(54) **Foil, electro-optic component and method of manufacturing these**

(71) Applicant: Nederlandse Organisatie voor Toegepast -Natuurwetenschappelijk Onderzoek TNO, 2628 VK Delft (NL); Koninklijke Philips N.V., 5656 AE Eindhoven (NL)
(72) Inventor: Young, Edward Willem Albert, 2628 VK Delft (NL); Hermes, Dorothee Christine, 2628 VK Delft (NL); Toonen, Leonardus Maria, 2628 VK Delft (NL); Lifka, Herbert, 5621 BA Eindhoven (NL)
(74) Representative: Jansen, Cornelis Marinus

(57) **Abstract**

The foil according to the present invention comprises a substrate (10) carrying an electrically conductive structure (20). The electrically conductive structure (20) is embedded in a barrier layer structure (30) having a first inorganic layer (32), a second inorganic layer (34) and an organic layer (36) between said inorganic layers, and the organic layer is partitioned by the electrically conductive structure into organic layer portions (36a). The electrically conductive structure comprises an enclosing mesh (24) and a plurality of mutually insulated electrically conductive elements (22a, 22b). The enclosing mesh (24) encloses mutually separate zones (26a, 26b) wherein respective ones of the mutually insulated electrically conductive elements (22a, 22b) are arranged.

## Description

### BACKGROUND OF THE INVENTION

### Field of the invention

The present invention relates to a foil comprising an electrically conductive structure embedded in a barrier layer.

The present invention further relates to an electro-optic component obtainable from said foil.

The present invention further relates to a method of manufacturing the foil and a method of manufacturing the electro-optic component.

### Related Art

For large area OLED lighting on flexible plastic substrates, a large current is required to drive the system. The present thin film materials used for the anode (e.g. ITO) and cathode (e.g. Ba/Al) have a large resistivity and the large currents give rise to a substantial voltage drop, which determine inhomogeneous light emission. For producing large area flexible OLED devices on plastic substrates there is a need for an additional metallization structure of the plastic substrate. For reducing the manufacturing costs, such structured metallization coatings will preferably be applied on rolls of plastic foil using an inline roll-to-roll web coating process. Accordingly, for electro-optic devices, such as light emitting devices, electro-chromic devices, and photo-voltaic products there is a need for a metallization structure that on the one hand has a good electrical conductivity, while on the other hand has a high transmission for radiation.

WO2010016763 describes an electric transport component that comprises a substrate provided with a barrier structure with a first inorganic layer, an organic decoupling layer and a second inorganic layer. At least one electrically conductive structure, for example a mesh, is accommodated in trenches in the organic decoupling layer. In the electric transport component the walls of the trenches support the mesh. Therewith the aspect ratio of the elements in the mesh can be relatively high. The aspect ratio is defined here as the height of the mesh, divided by the smallest dimension of said structure within the plane of the organic decoupling layer. The mesh is accommodated in the organic decoupling layer of the barrier structure. Therewith the organic decoupling layer serves a dual purpose and in manufacturing of the component only a single step is necessary to provide the organic decoupling layer that decouples the inorganic layers and that accommodates the mesh. Organic electro-optic devices often comprise materials that are sensitive to moisture. The known electric transport component provides for an electric signal or power transport function, as well as for a protection of the device against moisture.

In an embodiment of the known electric transport component the at least one trench extends over the full depth of the organic decoupling layer. This makes it possible to separate the electric transfer component, or an electro-optic device comprising the electric transfer component into parts. The electrically conductive structure embedded in the organic decoupling layer prevents a lateral distribution of moisture via the organic decoupling layer towards the electro-optic device.

In the case of most common electronic device designs on foil, OLEDs or OPVs, there is the need to define two electrode contacts for connecting the electrodes to a respective external electrical conductor, i.e. a contact for the bottom electrode of the device and a contact for the top electrode of the device.

The bottom electrode is herein defined as the one of the electrodes that is arranged closest to the mesh. The bottom electrode of the device is electrically contacted through the mesh at the sides of the device. The mesh provides a uniform current distribution to the device but in between the metal tracks of the mesh a current spreading layer is applied to provide a uniform power distribution. This can be a transparent organic conductor with sufficient conductivity. Depending on the application the mesh may have openings in the order of a mm to a few cm.

The top electrode requires a separate electric contact. The necessity to separately provide this contact complicates the manufacturing of the electro-optic component.

### The present invention

It is an object of the present invention to provide a foil suitable for manufacturing an electro-optic component that facilitates an electric connection to both electrodes while not limiting the dimensions of the electro-optic component to predetermined dimensions.

It is a further object of the present invention to provide a method of manufacturing such a foil.

It is a further object of the present invention to provide an electro-optic component that can be manufactured with the foil.

It is a still further object of the present invention to provide a method of manufacturing an electro-optic component from the foil.

According to a first aspect of the present invention a foil is provided as claimed in claim 1. The claimed foil can be used to manufacture electro-optic products. The claimed foil has an electrically conductive structure with a mesh and a plurality of mutually insulated electrically conductive elements that are laterally enclosed by the mesh in mutually separate zones. Therein respective ones of the mutually insulated electrically conductive elements are arranged. In an embodiment the electrically conductive elements are laterally separated parts of the mesh. According to a second aspect of the present invention a method of manufacturing a foil is provided as claimed in claim 8.

According to a third aspect of the present invention an electro-optic component is provided as claimed in claim 12.

According to a fourth aspect of the invention a method is provided as claimed in claim 14, for manufacturing an electro-optic component from the foil.

In the method according to the fourth aspect of the invention a first, translucent electrically conductive layer, an electro-optic layer and a second electrically conductive layer are applied over said electro-optic layer, therewith forming an electro-optic element. The second electrically conductive layer extends beyond the electro-optic layer over one or more enclosed electrically conductive elements. The enclosed electrically conductive elements can serve as an electric contact for the second electrically conductive layer. Although the enclosing mesh serves as a power distribution grid for the first electrically conductive layer, the latter may also cover one ore more enclosed electrically conductive elements provided that these are not the same that are covered by the second electrically conductive layer.

Subsequently a barrier layer is provided over the electro-optic component. Therein the barrier layer and the embedded mesh in the foil encapsulate the electro-optic component to form an encapsulated electro-optic component. In a subsequent step the encapsulated electro-optic component is separated from the remainder.

Therewith an encapsulated electro-optic component according to the fourth aspect of the invention is obtained as claimed in claim 12.

The foil according to the first aspect of the invention allows for an easy application of the electric contact of both electrically conductive layers, without restricting the dimensions of the encapsulated electro-optic component to be manufactured therewith to a predetermined size. Relatively small sized components may be manufactured, wherein a single one of the electrically conductive elements, for example a laterally separated portion of the mesh is used to contact. But also larger components can be manufactured, wherein the electro-optic component extends over a larger area with a plurality of mutually electrically insulated elements. It is therewith no objection that the first, transparent electrical conductive layer overlaps also electrically conductive elements of the mesh, provided that these do not serve as contact points for the second electrical conductive layer. In this case the first, transparent electrical conductive layer reconnects the electrically conductive elements with the mesh, and therewith provides for a current distribution in the enclosed zone in cooperation with the electrically conductive element in the enclosed zone.

In an embodiment the mutually insulated electrically conductive elements have a bounding box with a smallest dimension in a range between 0.5 and 3 times the square root of the average area of openings enclosed by the mesh. A substantially smaller dimension, e.g. less than 0.1 times the square root of the average area of openings would make it difficult to obtain an adequate electrical connection between the second electrically conductive layer and the insulated electrically conductive element. A substantially larger smallest dimension, e.g. more than 5 times the square root of the average area of openings, would not further improve the electrical connection with the second electrically conductive layer. Hence, when it is used to provide the electrical contact for the second electrically conductive layer, it would occupy an unnecessary large space which can not be used for depositing the first electrically conductive layer.

In embodiments the bounding box has a largest dimension in the range between 1.5 and 10 times its smallest dimension. A largest dimension substantially greater than 10 times the smallest dimension, e.g. 50 times the smallest dimension would too much restrict the number of ways in which the foil can be partitioned in the process of manufacturing an electro-optic component. A largest dimension less than 1.5 times would result in an unnecessarily fine partitioning of the mesh which would impede the conductivity of the electrically conductive element.

In an embodiment the shortest distance between an insulated electrically conductive element and the enclosing mesh portion is in the range between 1 and 5 times the width of the mesh elements. A substantially smaller distance, e.g. less than 0.5 times the width of the mesh elements would necessitate small production tolerances, to prevent that the insulated electrically conductive element and the enclosing mesh portion contact each other. In areas wherein the insulated electrically conductive element is covered by the first, transparent electrically conductive layer, electrical conduction over this distance is only possible via this transparent layer. In this case a distance, substantially larger than the 5 times the width of the mesh elements, e.g. larger than 10 times the width of the mesh elements, would result in a too inhomogeneous distribution of the current.

### BRIEF DESCRIPTION OF THE DRAWINGS

These and other aspects are described in more detail with reference to the drawing. Therein:
FIGs. 1A and 1B schematically show a first embodiment of a foil according to the first aspect of the invention,
Therein FIG. 1A is a top-view and FIG. 1B is a cross-section according to B-B in FIG. 1A,
FIG. 1C shows a second embodiment of the foil,
FIG. 1D shows a third embodiment of the foil,
FIG. 1E shows a fourth embodiment of the foil,
FIG. 1F shows a fifth embodiment of the foil,
FIG. 2 shows a sixth embodiment of the foil,
FIG. 2A shows a seventh embodiment of the foil,
FIG. 2B shows an eight embodiment of the foil,
FIG. 2C shows a ninth embodiment of the foil,
FIG. 2D shows a tenth embodiment of the foil,
FIG. 3A shows a eleventh embodiment of the foil,
FIG. 3B shows a twelfth embodiment of the foil,
FIG. 4A to 4H show a first embodiment of a method according to the second aspect of the invention,
FIG. 5A to 5E show a second embodiment of a method according to the second aspect of the invention,
FIG. 6A-6H show a third embodiment of a method according to the second aspect of the invention,
FIG. 7 shows an embodiment of an electro-optic component according to the third aspect of the invention,
FIG. 8A to 8E show an embodiment of a method of manufacturing an electro-optic component according to the fourth aspect of the invention.

### DETAILED DESCRIPTION OF EMBODIMENTS

In the following detailed description numerous specific details are set forth in order to provide a thorough understanding of the present invention. However, it will be understood by one skilled in the art that the present invention may be practiced without these specific details. In other instances, well known methods, procedures, and components have not been described in detail so as not to obscure aspects of the present invention.

The terminology used herein is for the purpose of describing particular embodiments only and is not intended to be limiting of the invention. As used herein, the singular forms "a", "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

Further, unless expressly stated to the contrary, "or" refers to an inclusive or and not to an exclusive or. For example, a condition A or B is satisfied by any one of the following: A is true (or present) and B is false (or not present), A is false (or not present) and B is true (or present), and both A and B are true (or present).

The invention is described more fully hereinafter with reference to the accompanying drawings, in which embodiments of the invention are shown. This invention may, however, be embodied in many different forms and should not be construed as limited to the embodiments set forth herein. Rather, these embodiments are provided so that this disclosure will be thorough and complete, and will fully convey the scope of the invention to those skilled in the art. In the drawings, the size and relative sizes of layers and regions may be exaggerated for clarity.

It will be understood that when an element or layer is referred to as being "on", "connected to" or "coupled to" another element or layer, it can be directly on, connected or coupled to the other element or layer or intervening elements or layers may be present. In contrast, when an element is referred to as being "directly on," "directly connected to" or "directly coupled to" another element or layer, there are no intervening elements or layers present. Like numbers refer to like elements throughout. As used herein, the term "and/or" includes any and all combinations of one or more of the associated listed items.

It will be understood that, although the terms first, second, third etc. may be used herein to describe various elements, components, regions, layers and/or sections, these elements, components, regions, layers and/or sections should not be limited by these terms. These terms are only used to distinguish one element, component, region, layer or section from another region, layer or section. Thus, a first element, component, region, layer or section discussed below could be termed a second element, component, region, layer or section without departing from the teachings of the present invention.

Spatially relative terms, such as "beneath", "below", "lower", "above", "upper" and the like, may be used herein for ease of description to describe one element or feature's relationship to another element(s) or feature(s) as illustrated in the figures.

It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features. Thus, the exemplary term "below" can encompass both an orientation of above and below. The device may be otherwise oriented (rotated 90 degrees or at other orientations) and the spatially relative descriptors used herein interpreted accordingly.

Embodiments of the invention are described herein with reference to cross-section illustrations that are schematic illustrations of idealized embodiments (and intermediate structures) of the invention. As such, variations from the shapes of the illustrations as a result, for example, of manufacturing techniques and/or tolerances, are to be expected. Thus, embodiments of the invention should not be construed as limited to the particular shapes of regions illustrated herein but are to include deviations in shapes that result, for example, from manufacturing.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein. All publications, patent applications, patents, and other references mentioned herein are incorporated by reference in their entirety. In case of conflict, the present specification, including definitions, will control. In addition, the materials, methods, and examples are illustrative only and not intended to be limiting.

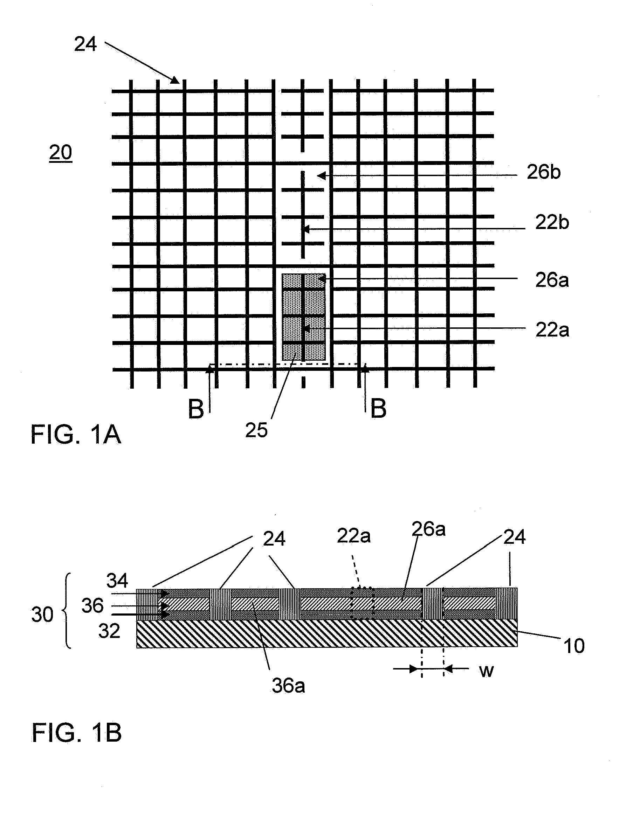

FIGs. 1A and 1B schematically show a foil with a substrate 10 that carries a structure 20 of an electrically conductive material, further also denoted as electrically conductive structure. Therein FIG. 1A is a top-view and FIG. 1B is a cross-section according to B-B in FIG. 1A. The electrically conductive material is for example a metal like aluminum, titanium, copper, steel, iron, nickel, silver, zinc, molybdenum, chromium or alloys thereof The substrate is preferably from a resin base material. Such resin base materials preferably include polyethylene terephthalate (PET), polyethylene naphthalate (PEN), polyimide (PI), polyetherimide (PEI), polyethersulfone (PES), polysulfone (PSF), polyphenylene sulfide (PPS), polyether ether ketone (PEEK), polyarylate (PAR), and polyamide-imide (PAI). Other resin materials include polycycloolefin resin, acrylic resin, polystyrene, ABS, polyethylene, polypropylene, polyamide resin, polyvinyl chloride resin, polycarbonate resin, polyphenyleneether resin and cellulose resin, etc.

As can be seen in FIG. 1A, the electrically conductive structure 20 comprises a plurality of mutually insulated electrically conductive elements 22a, 22b. The electrically conductive structure 20 further comprises a mesh 24 that encloses mutually separate zones 26a, 26b wherein respective ones of the mutually insulated electrically conductive elements 22a, 22b are arranged. In the embodiments shown exactly one insulated electrically conductive elements is arranged in each zone. In the embodiment shown, the mutually insulated electrically conductive elements 22a, 22b are laterally separated portions of the mesh 24. It could be considered to have more than one insulated electrically conductive element per zone, but this would not have beneficial effects. Turning now to FIG. 1B it can be seen that the electrically conductive structure is embedded in a barrier structure 30 that has a first inorganic layer 32, a second inorganic layer 34 and an organic layer 36 between said inorganic layers 32, 34. The second inorganic layer 34 and the organic layer 36 are partitioned by the mesh 24 into organic layer portions 36a. In this case the organic layer portions 36a are encapsulated by the first inorganic layer 32, the second inorganic layer 34 and the mesh 24. The material of the electrically conductive structure 20, as well as the material of the second inorganic layer 34 form a barrier for moisture. Accordingly, the upper surface of the foil as shown in FIG. 1A, 1B that comprises surface portions of the inorganic layer 34 and surface portions of the electrically conductive structure 20, forms a barrier surface. On the opposite side of the foil the first inorganic layer 32 and surface portions of the electrically conductive structure 20 forms a barrier surface. The organic layer may be provided from a cross-linked (thermoset) material, an elastomer, a linear polymer, or a branched or hyper-branched polymer system or any combination of the aforementioned, optionally filled with inorganic particles of a size small enough to still guarantee light transmission. The material is processed either from solution or as a 100% solids material. Curing or drying may exemplary occur by irradiation of the wet material, pure, or suitably formulated with a photo- or heat-sensitive radical or super-acid initiator, with UV-light, visible light, infrared light or heat, E-beam, g-rays or any combination of the aforementioned. The material of the organic layer preferably has a low specific water vapour transmission rate and a high hydrophobicity. Examples of suitable cross-linking (thermoset) systems are any single one or any combination of aliphatic or aromatic epoxy acrylates, urethane acrylates, polyester acrylates, polyether acrylates, saturated hydrocarbon acrylates, epoxides, epoxide-amine systems, epoxide-carboxylic acid combinations, oxetanes, vinyl ethers, vinyl derivatives, and thiol-ene systems. Suitable examples of elastomeric materials are polysiloxanes. Examples of suitable branched or linear polymeric systems are any single one or any copolymer or physical combination of polyacrylates, polyesters, polyethers, polypropylenes, polyethylenes, polybutadienes, polynorbornene, cyclic olefin copolymers, polyvinylidenefluoride, polyvinylidenechloride, polyvinylchloride, polytetrafluoroethylene, polychlorotrifluoroethylene, polyhexafluoropropylene. The organic layers may have a thickness between 0.1 - 100 µm, preferably between 5 and 50 µm.

The inorganic layers may be any translucent ceramic including but not limited to metal oxide, silicon oxide (SiO2), aluminum oxide (A12O3), titanium oxide (TiO2), silicon nitride (SiN), silicon oxynitride (SiON) and combinations thereof.

The inorganic layers have a water vapour transmission rate of at most 10⁻⁴ g.m⁻².day⁻¹.

The inorganic layers are in practice substantially thinner than the organic layers. The inorganic layers should have a thickness in the range of 10 to 1000 nm, preferably in the range of 100 to 300 nm.

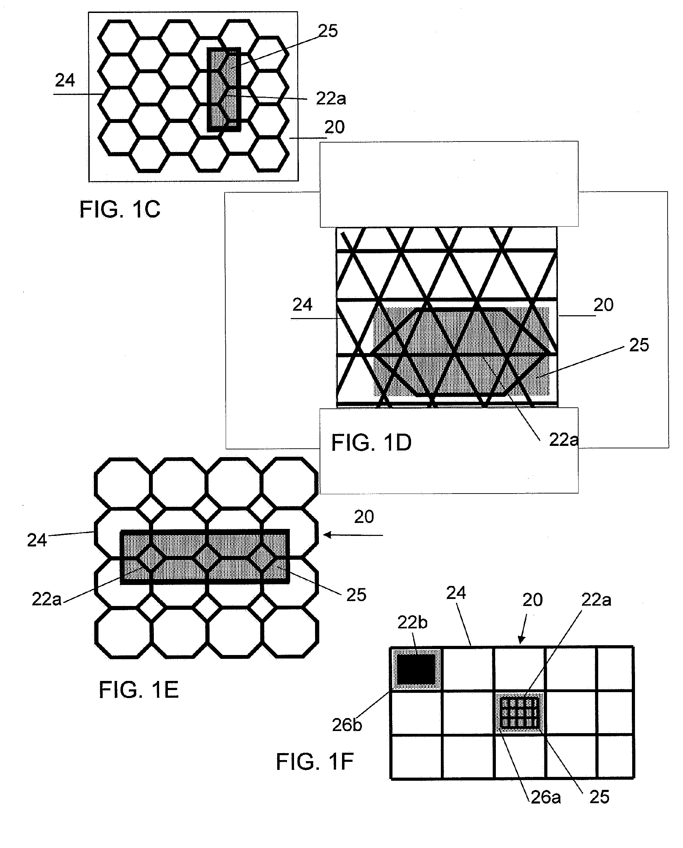

In the embodiment shown, the mesh 24 is formed as a regular grid with square openings. In other embodiments the mesh 24 may have hexagonal openings as shown in FIG. 1C, or triangular openings as shown in FIG. 1D for example. The mesh 24 need not be regular, as is illustrated in FIG. 1E for example.

In the embodiment shown in FIG. 1A the mesh 24 has square openings with an area LxL, wherein L is the length of the mesh elements between each pair of neighboring nodes in the mesh. In the embodiment of FIG. 1A, the bounding box 25 has a smallest dimension Wb which is 1.9xL. Accordingly, the mutually insulated electrically conductive elements 22a, 22b enclosed by the mesh 24 have a bounding box 25 with a smallest dimension in a range between 0.5 and 3 times the square root of the average area of openings enclosed by the mesh 24.

In the embodiment shown in FIG. 1C, the openings have a size equal to 2.6 L², wherein L is the length of the mesh elements between each pair of neighboring nodes in the mesh 24. Accordingly, the square root of the openings is about 1.6 L. In the embodiment shown the smallest dimension of the bounding box is about L, which is in the range of between 0.5 and 3 times the square root of the average area of openings enclosed by the mesh 24.

In the embodiment shown in FIG. 1D, the openings have a size equal to 0.86 L², wherein L is the length of the mesh elements between each pair of neighboring nodes in the mesh 24. Accordingly, the square root of the openings is about 0.93 L. In the embodiment shown the smallest dimension of the bounding box is about 1.73 L, which is in the range of between 0.5 and 3 times the square root of the average area of openings enclosed by the mesh 24.

FIG. 1E shows an example of an irregular mesh 24. Therein the openings have an average size equal to 2.4 L², wherein L is the length of the mesh elements between each pair of neighboring nodes in the mesh. Accordingly, the square root of the openings is about 1.55 L. In the embodiment shown the smallest dimension of the bounding box is about 2.4 L, which is in the range of between 0.5 and 3 times the square root of the average area of openings enclosed by the mesh 24.

It can also be verified that in each of the embodiments shown in FIG. 1A to 1E, the bounding box 25 has a largest dimension in the range between 1.5 and 10 times its smallest dimension.

In the embodiments shown the shortest distance between an insulated electrically conductive element 22a, 22b and the enclosing mesh 24 is in the range between 1 and 5 times the width w of the mesh elements.

In the embodiments shown in FIG. 1A-1E, the electrically conductive elements 22a, 22b, and the mesh 24 are laterally separated portions of a mesh formed by the electrically conductive structure 20. This is not necessary however. By way of example, FIG. 1F shows an embodiment wherein an electrically conductive element 22a is formed by another mesh having smaller grid dimensions than that of the mesh 24. FIG. 1F also shows an electrically conductive element 26b formed by a solid portion of an electrically conductive material. As can be seen in FIG. 1A, a plurality of mutually separate zones is arranged in a row according to the length direction of the bounding box 25. The bounding boxes 25 of two subsequent mutually insulated electrically conductive elements 22a, 22b have a mutual distance that is less than the square root of the average area of openings enclosed by the mesh 24. For example in FIG. 1A, the square root of the average area of openings is equal to the length L, whereas the mutual distance of the bounding boxes 25 is less than 0.5 L.

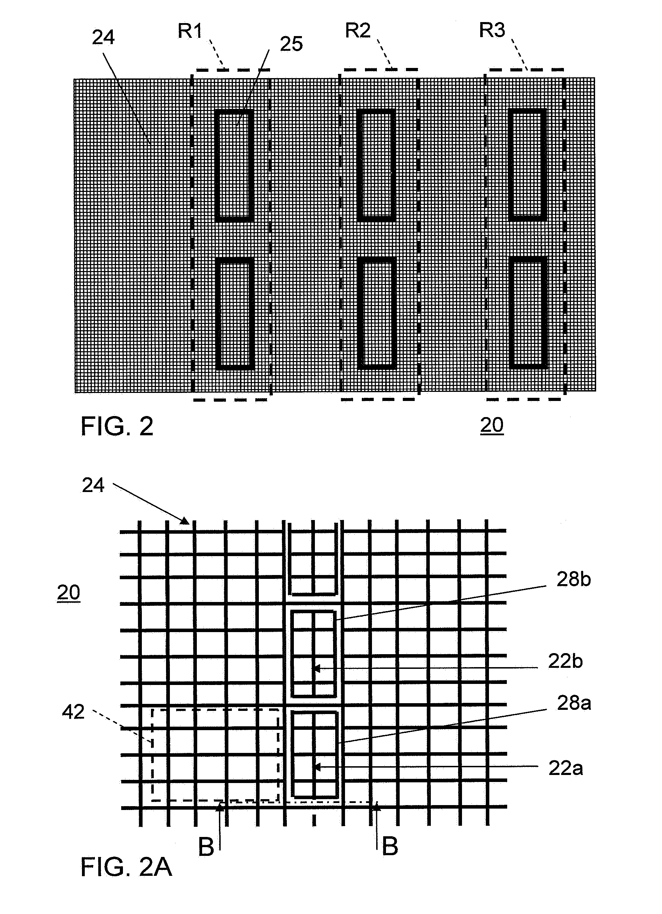

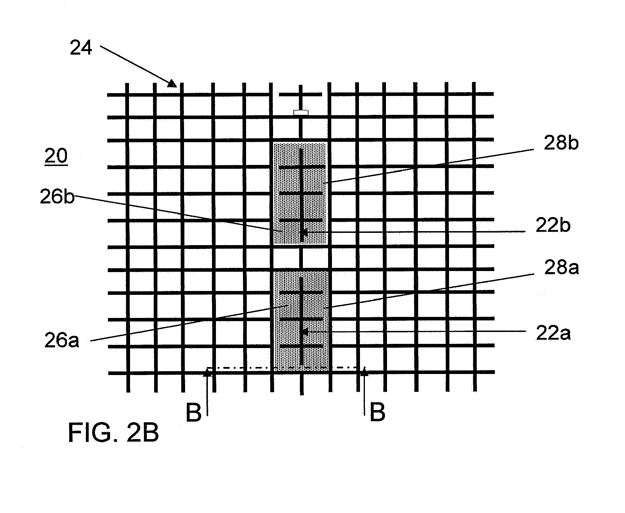

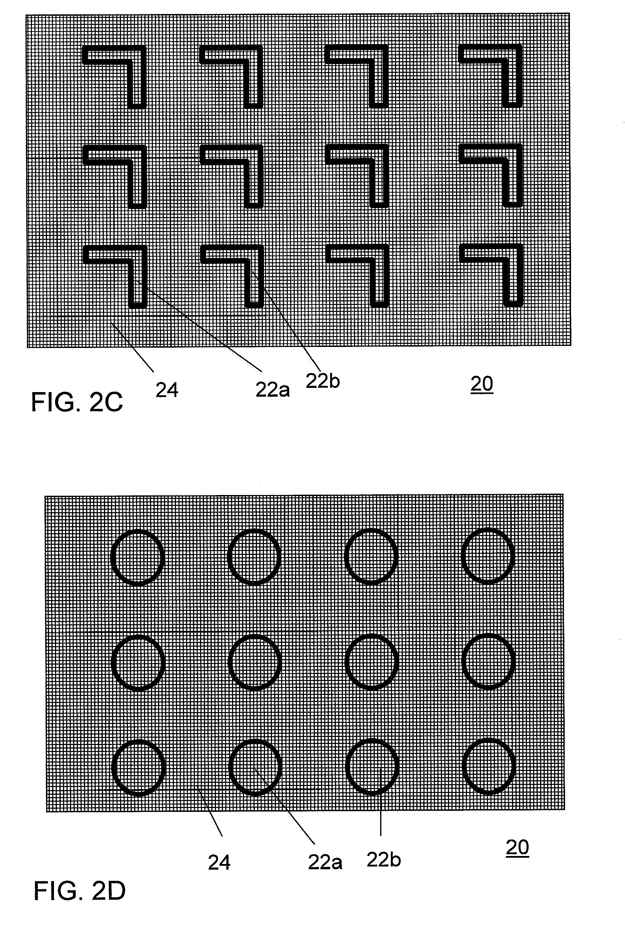

By way of example, FIG. 2 schematically shows a foil having a plurality of rows R1, R2, R3.

In order to improve electric conductivity between the mutually insulated electrically conductive elements 22a and 22b on the one hand and the enclosing mesh 24 on the other hand, the mutually insulated elements, also denoted as enclosed portions 22a, 22b may be provided with a ring conductor 28b as shown in FIG. 2A.

In the embodiment shown in FIG. 2B two subsequent mutually separate zones 26a, 26b in a row have a respective boundary. The product to be manufactured can be cut from the remainder along a cutting line extending between the respective boundaries, so that the zones 26a, 26b both remain laterally enclosed.

Although the mutually insulated portions typically are arranged in a rectangular zone within the enclosing mesh 24, also other embodiments may be considered as shown in FIG. 2C and 2D for example, the zones for the mutually insulated electrically conductive elements 22a, 22b may have a deviating shape, such as hook-shaped zones of FIG. 2C and circular zones of FIG. 2D.

Several options are possible for the arrangement of the inorganic layers in the barrier layer structure 30 wherein the electrically conductive structure 20 is embedded. FIG. 1B shows an embodiment wherein both inorganic layers 32 and 34 are arranged within and partitioned by the electrically conductive structure 20.

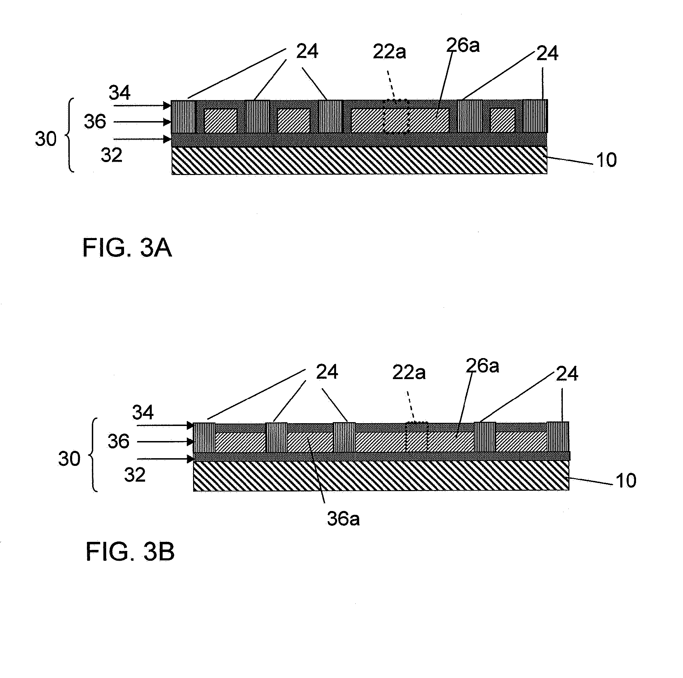

FIG. 3A and 3B shows two arrangements wherein the first inorganic layer 32 is a continuous layer.

As in FIG. 1A, 1B the upper surface of the foil that comprises surface portions of the inorganic layer 34 and surface portions of the electrically conductive structure 20a, 24 forms a barrier surface. On the opposite side of the foil the inorganic layer 32 forms a barrier surface.

A foil according to the present invention can be manufactured with a method according to the second aspect of the invention. A method according to the second aspect of the invention generally comprises the steps of
- providing a substrate 10,
- providing the substrate with a barrier layer structure 30 with an embedded electrically conductive structure 20, the barrier layer structure 30 comprising a first inorganic layer 32, a second inorganic layer 34 and an
organic layer 36 between said inorganic layers, said organic layer being partitioned by the mesh, into organic layer portions 36a, the electrically conductive structure 20 comprising an enclosing mesh 24 and a plurality of mutually insulated electrically conductive elements 22a, 22b, wherein the enclosing mesh encloses mutually separate zones 26a, 26b wherein respective ones of the mutually insulated electrically conductive elements 22a, 22b are arranged.

A method according to the second aspect of the invention can be carried out in various ways of which some are described now in more detail.

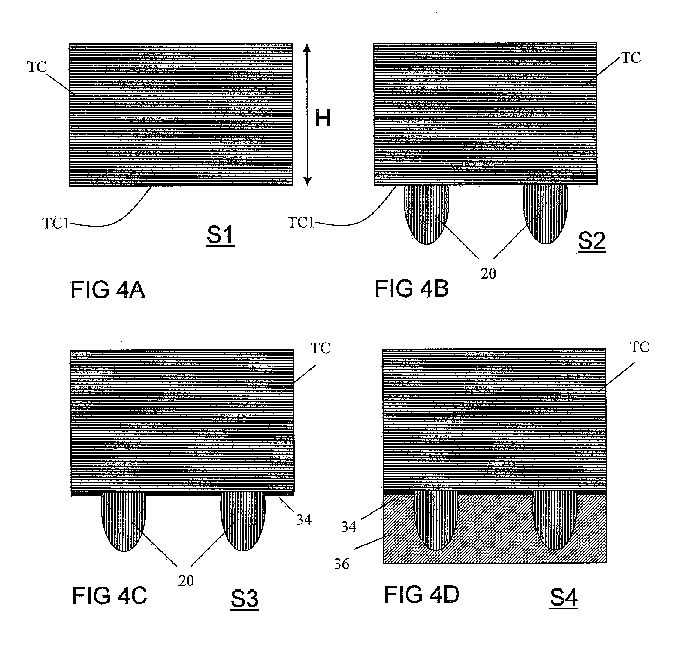

FIG. 4A to 4H show a first embodiment of a method according to the second aspect of the invention.

In a first step S1 shown in FIG. 4A a temporary carrier TC is provided. The temporary carrier TC is for example a metal foil.

In a subsequent step S2 the electrically conductive structure 20 is deposited on a main side TC1 of the temporary carrier.

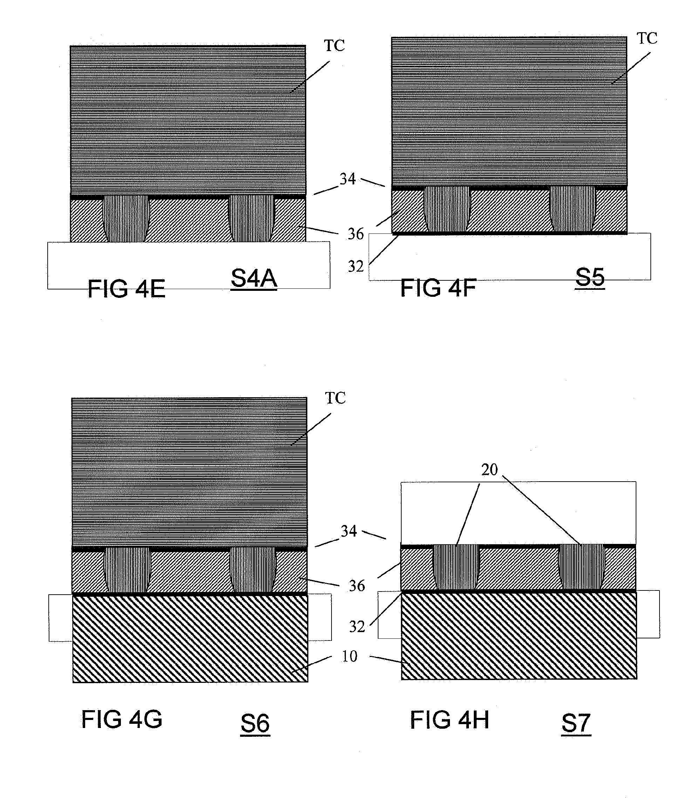

In further subsequent steps S3 (See FIG. 4C), S4 (See FIG. 4D) and S5 (See FIG. 4F) respectively the second inorganic layer 34, the organic layer 36 and the first inorganic layer are deposited in spaces left open by the electrically conductive structure, i.e. in the openings of the electrically conductive structure. It is important that no organic material is deposited or remains on the free surface of the electrically conductive structure 20. This is to prevent that moisture or other harmful substances can laterally diffuse through the organic layer. This can be achieved for example by applying a dewetting material on that free surface before the step S4 of depositing the organic material. Alternatively the organic material may be mechanically or chemically removed (Step S4A in FIG. 4E) from that free surface afterwards. Subsequent to the step of depositing the first inorganic layer 32, the so obtained stack of layers is laminated in step S6 with the substrate 10 (See FIG. 4G). Step S6 shows how the substrate 10 is laminated at a free surface of the first inorganic layer 32. Subsequently the temporary carrier TC is removed in step S7, a shown in FIG. 4H. Suitable materials and processing methods for manufacturing the foil according to this method are described in WO2011/016725. The method described in FIG. 4A to 4H results in a foil as shown in FIG. 3B.

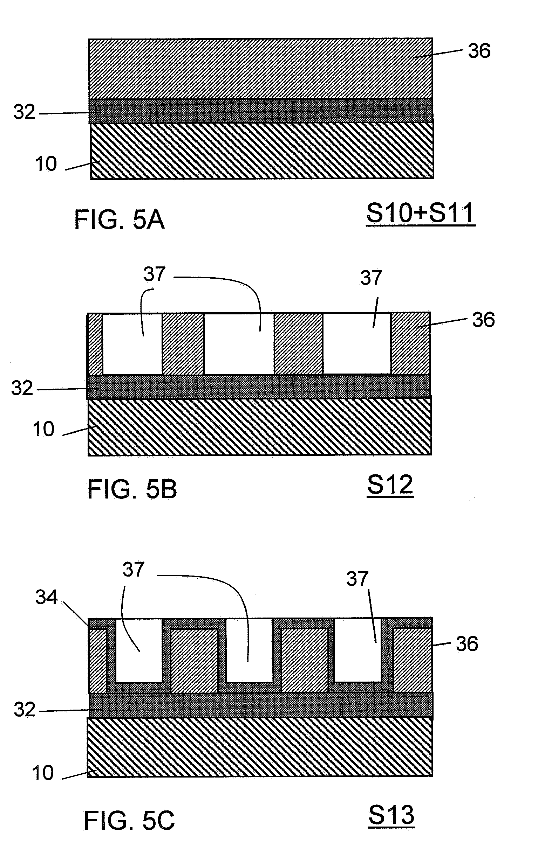

An alternative method described with reference to FIG. 5A to 5E.

In the embodiment shown, the substrate 10 is provided, upon which in subsequent steps S10 and S11 a first inorganic layer 32 and an organic layer 36 is deposited. The result of these steps is shown in FIG. 5A. In addition intermediate layers may be present between the substrate 10 and the first inorganic layer 32, for example a planarization layer. Likewise, intermediate layers may be present between the first inorganic layer 32, and the organic layer 36.

Figure 5B shows a further step S12, wherein a plurality of trenches 37 is formed in the organic layer 36. The trenches are formed in a pattern conformal to the desired pattern of the electrically conductive structure 20 to be formed.

In order to form the trenches in the organic decoupling layer for example soft lithography (embossing PDMS rubber stamp into a partially reacted organic layer) may be applied. In this way trenches are formed that can have an aspect ratio of up to 10.

Further the organic decoupling layer is fully cured after imprinting e.g. by polymerization using a heat-treatment or UV-radiation.

Alternatively, the organic layer 36 and the pattern of tranches may be formed in a single step, e.g. by printing the organic layer in a pattern complementary to the pattern of trenches 37.

The trenches 37 are treated such that no organics remain in bottom of the trench on top of the first inorganic barrier layer 32. A plasma etch might be used for this cleaning. Remaining organic material could form a diffusion path for moisture.
As shown in Figure 5C, the organic layer 36 is subsequently covered with a second inorganic layer 34 in step S13.

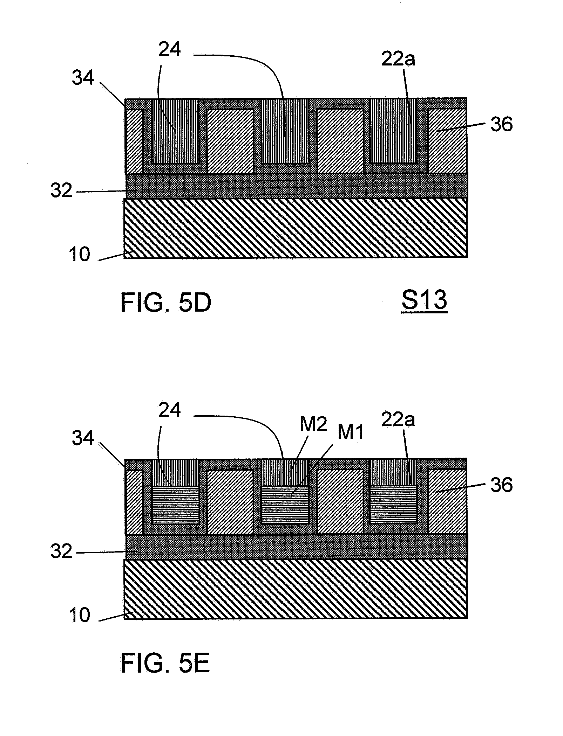

In a further step an electrically conductive material that is to form the electrically conductive structure 22a, 24 is deposited in the trenches 37. Therewith the semi-finished product shown in FIG. 5D is obtained. This can be used to obtain the foil of FIG. 3A.

To mitigate that the conductive material spreads out at the surface, the top surface is made hydrophobic and the trenches are made hydrophilic. The trenches may be filled in a single step, for example by sputtering, or by vapor deposition, such as MOCVD, and combining this with the step of polishing or etching. Preferably the trenches are filled with a two-stage process. For example the trenches can be filled with an evaporated metal (e.g. A1 like in publication EP 1 693 481 A1) or with solution based metals (e.g. Ag, Au, Cu) and an extra baking step (below 150 C). The next process is to fill completely the trenches in order to compensate for shrinkage of the material in the trenches. The electrically conductive material applied during the second step may be the same, but may alternatively be a different material. In that case, suitable metals for the first layer M1, having a relatively high conductivity are for example Ag, Au, Cu and Al. Suitable materials for the second layer M2, having relatively high reflectivity, are for example Cr, Ni and A1.. See FIG. 5E. In an embodiment the first and the second layer may be separated by one or more intermediary layers, for example by a diffusion barrier layer, e.g. of Cr, Ti or Mo. During this process attention should be paid to the electrically conductive structure design such that the contact area for an electrically conductive layer of a functional component that is to be assembled with the electrical transport component does not come in direct contact with another conductive layer of the functional component, in order to prevent shortcuts. In an alternative method the electrically conductive material is applied in a single step.

An inline vacuum or air based roll-to-roll web coating system known as such may be used to apply the organic and inorganic layers. The coating system consists of multiple sections combining an unwind, a rewind and in between a multiple of process chambers dedicated for example to pre-treat a substrate surface, or coat a substrate surface with an inorganic layer, or coat a substrate surface with an organic layer, or coat a substrate surface with a patterned organic layer, or cure an organic coated surface.

The inorganic layers may be applied by all kinds of physical vapor deposition methods such as thermal evaporation, e-beam evaporation, sputtering, magnetron sputtering, reactive sputtering, reactive evaporation, etc. and all kinds of chemical vapor deposition methods such as thermal chemical vapor deposition (CVD), photo assisted chemical vapor deposition (PACVD), plasma enhanced chemical vapor deposition (PECVD), etc.

The organic layer may be applied by all kinds of coatings techniques, such spin coating, slot-die coating, kiss-coating, hot-melt coating, spray coating, etc. and all kinds of printing techniques, such as inkjet printing, gravure printing, flexographic printing, screen printing, rotary screen printing, etc.

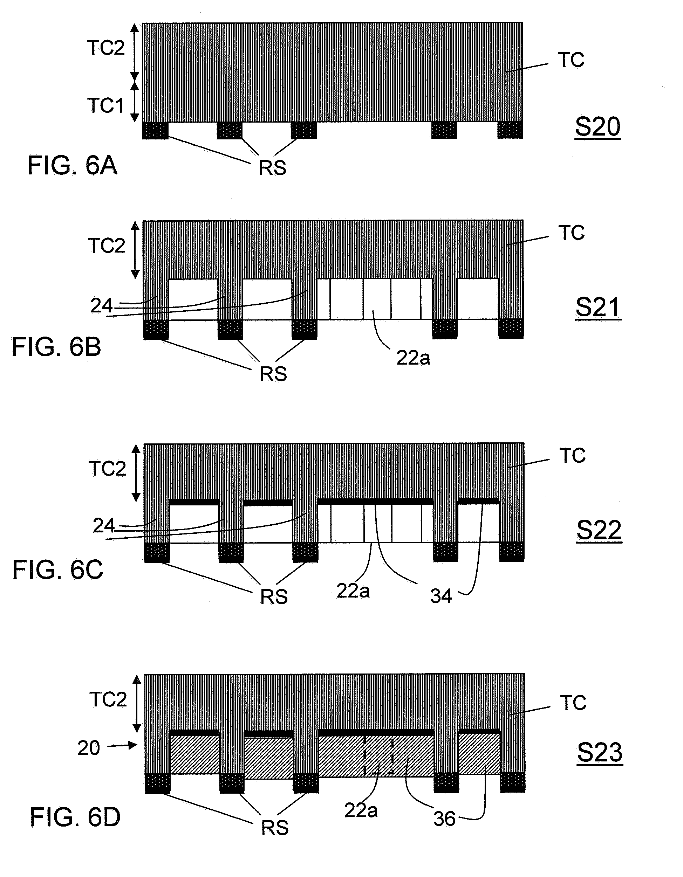

A still further embodiment of the method according to the second aspect of the invention is shown in FIG. 6A-6G. The method comprises a first step S20 of providing a metal foil TC having a first surface portion TC1 and a carrier portion TC2. The first surface portion TC1 and the carrier portion TC2 may be of the same metal, but alternatively mutually different metals may be used.

In a second step S21, shown in FIG. 6B the first surface portion TC1 of the foil TC is patterned according to a pattern that is conformal with the electrically conductive structure to be formed. Therewith a surface of the carrier portion TC2 is exposed. In the embodiment shown the first surface portion TC1 of the foil is patterned by etching using a resist mask RS in a pattern complementary to that of the electrically conductive structure to be formed. Alternatively, the pattern may be formed by imprinting using a stamp.

Subsequently, in step S22 shown in FIG. 6C, the exposed surface of the carrier portion TC2 is coated with the second inorganic layer 34.

In step S23, shown in FIG. 6D, the organic layer is deposited over the coated and patterned first surface. In the embodiment shown, it is avoided that the mesh is covered with the material used for the organic layer, as it is still covered by the resist mask RS. Alternatively, the material used for the organic layer may be removed after the deposition step S23, e.g. by polishing.

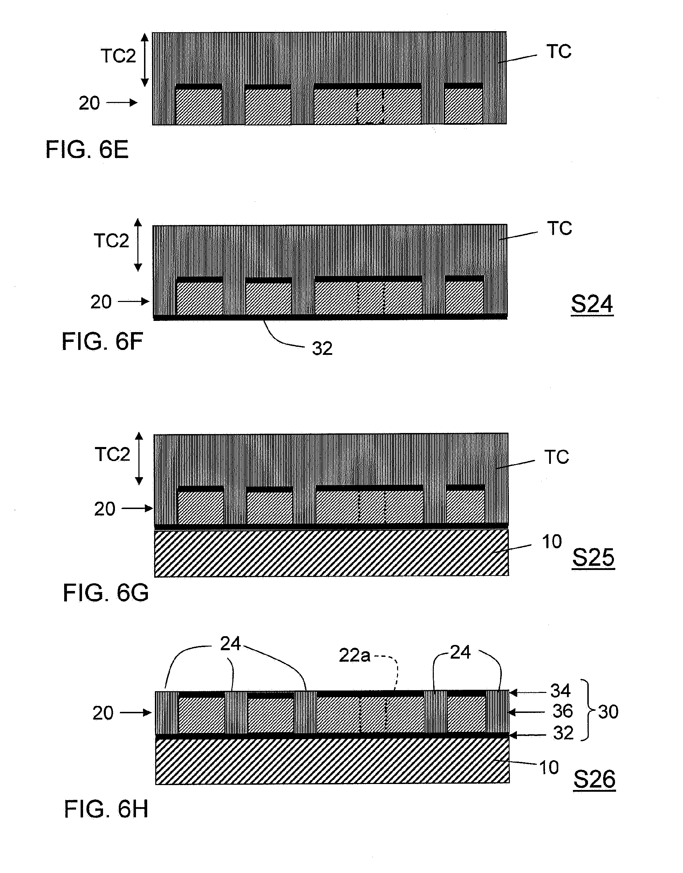

Therewith a patterned surface portion is obtained with a free surface as shown in FIG. 6E.

Subsequently, in step S24, shown in FIG. 6F the first inorganic layer 32, is deposited.

FIG. 6G shows a subsequent step S25, wherein the stack of layers so obtained is laminated with the substrate 10. The substrate 10 is laminated at the side of the first inorganic layer 32. One or more intermediary layers, such as an adhesive layer may be present between the first inorganic layer 32 and the substrate 10.

After lamination the carrier portion TC2 of the metal foil TC is removed, so that only the metal structure, forming the electrically conductive structure 20, embedded in the barrier 32, 36, 34 and carried by the substrate 10 remains. Removal of the carrier portion TC2 takes place in a step S26 as shown in FIG. 6H.

Further details about this method can be found in WO 2011/016724 for example. Alternatively, or in addition it is possible to provide the metal substrate in the form of a first and a second metal layer 10a, 10b that are separated by an etch stop layer 10c, as is shown in Figure 2J. For example the metal foil TC used may comprise a carrier portion TC2 formed by a copper layer having a thickness of 90 µm, and a first surface portion TC1 formed by a second copper layer 10b having a thickness of 10 µm. The etch stop layer 10c , e.g. a layer of TiN, may be removed after the step S26 of removing the carrier portion TC2 and before further layers are applied at the embedded electrically conductive structure 20.

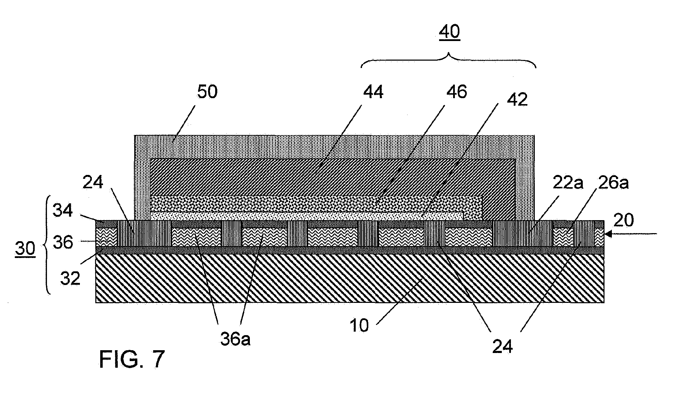

FIG. 7 shows an electro-optic component with a substrate 10 carrying an electrically conductive structure 20 of an electrically conductive material. The electrically conductive structure 20 is embedded in a barrier structure 30 with a first inorganic layer 32, a second inorganic layer 34 and an organic layer 36 between the first and the second inorganic layer. The second inorganic layer 34 and the organic layer 36 are partitioned by the electrically conductive structure. In the embodiment shown the first inorganic layer 32 is uninterrupted, but in other embodiments the first inorganic layer may also be partitioned by the electrically conductive structure. The partitioned organic layer portions 36a resulting from the said partition are encapsulated by the first inorganic layer 32, the second inorganic layer 34 and the electrically conductive structure 20. The electrically conductive structure 20 comprises a mesh 24 and an electrically conductive element 22a, insulated from and enclosed by the mesh 24. The electrically conductive element 22a is arranged in a zone 26a that is enclosed by the mesh 24. The electro-optic component further comprises an electro-optic element 40 with a first translucent electrically conductive layer 42, a second electrically conductive layer 44 and an electro-optic layer 46 arranged between the first and the second electrically conductive layer. The first translucent electrically conductive layer 42 is applied at a surface of the mesh 24 facing away from the substrate 10. The second electrically conductive layer 44 extends laterally beyond the first translucent electrically conductive layer 42 and there the electro-optic layer 46 physically and electrically contacts the electrically conductive element 22a. The first translucent electrically conductive layer may of an organic type, such as polyaniline, polythiophene, polypyrrole or doped polymers. Apart from organic materials, various inorganic transparent, electrically conducting materials are available like ITO (Indium Tin Oxide), IZO (Indium Zinc Oxide), ATO (Antimony Tin Oxide), or Tin Oxide can be used. Other metal oxides can work, including but not limited to Nickel-Tungsten-Oxide, Indium doped Zinc Oxide, Magnesium-Indium-Oxide.

The second electrically conductive layer 44 does not need to be transparent. In an embodiment the second electrically conductive layer 44 may comprise sub-layers, for example a sub-layer of Ba having a thickness of about 5 nm, arranged against the electro-optic layer, and a sub-layer of aluminium having a thickness in the range of 100-400 nm

Dependent on the type of electro-optic element, e.g. photo-voltaic device, light-emitting device or electro-chrome device, the electro-optic layer 46 may comprise a plurality of sub-layers. For example in a light-emitting device, the electro-optic layer 46 may for example comprise in addition to a light-emitting sub-layer further comprise a hole-injection layer, an electron-injection layer etc.

In the embodiment shown, the electro-optic layer 46 extends beyond the first electrically conductive layer in the direction of the electrically conductive element 22a and therewith provides for an insulation between the first and the second electrically conductive layer 42, 44.

The electro-optic component further comprises a protection layer 50 that in combination with the barrier structure 30 formed by the layers 32, 34, 36 and the electrically conductive structure 20 embedded therein encloses the electro-optic element 40 therewith providing a protection against ingress of moisture. The protection layer 50 typically comprises a stack of sub-layers. In a first embodiment the protection layer 50 is a stack comprising an organic sub-layer sandwiched between a first and a second inorganic sub-layer. The stack may comprise further organic and inorganic sub-layers that alternate each other. The organic sub-layers may comprise a moisture getter. Alternatively the protection layer 50 may comprise a stack of sub-layers of different inorganic materials that alternate each other.
As can be seen in FIG. 7, an insulated electrically conductive element 22a should be sufficiently large to provide an electric contact for an electrode 44 of the electro-optic device, and for providing an external contact, while still leaving room between these contacts for an encapsulation material of the protection layer 50. This implies that in at least in one direction the bounding box should have a dimension that is at least about 1 mm. However, less strict production tolerances are required if the dimension in that direction is at least 10 mm. However, preferably the dimension of the bounding box in that direction is less than 3 cm. In the other direction the bounding box may have a comparable size up to a size that is 5 times larger.

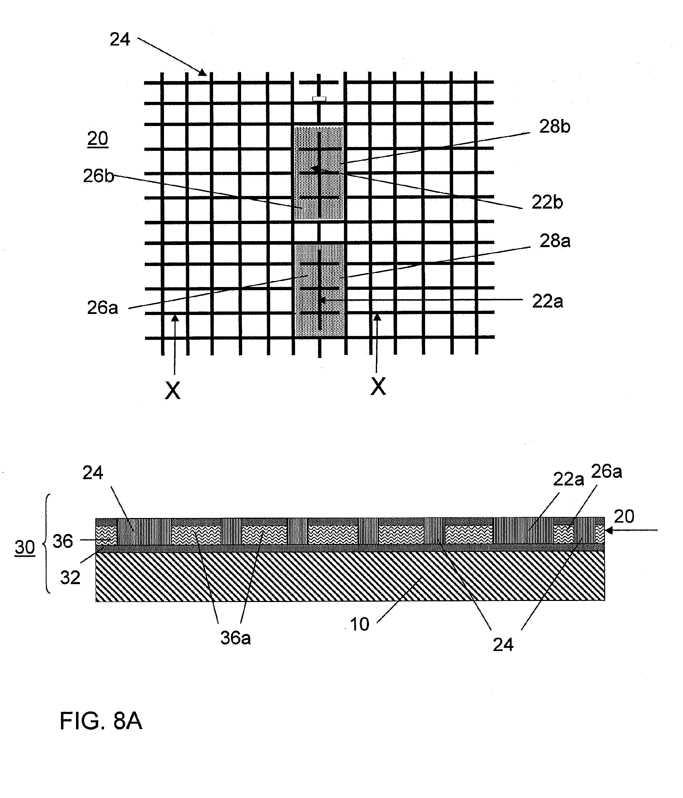

A method of manufacturing an electro-optic component from a foil as described above, for example the foil of FIG. 3B, is described now with reference to FIG. 8A to 8E. Therein the top part of each of these figures shows as top-view of the work piece and the bottom part shows a cross-section according to X-X

FIG. 8A shows the foil used in this example.

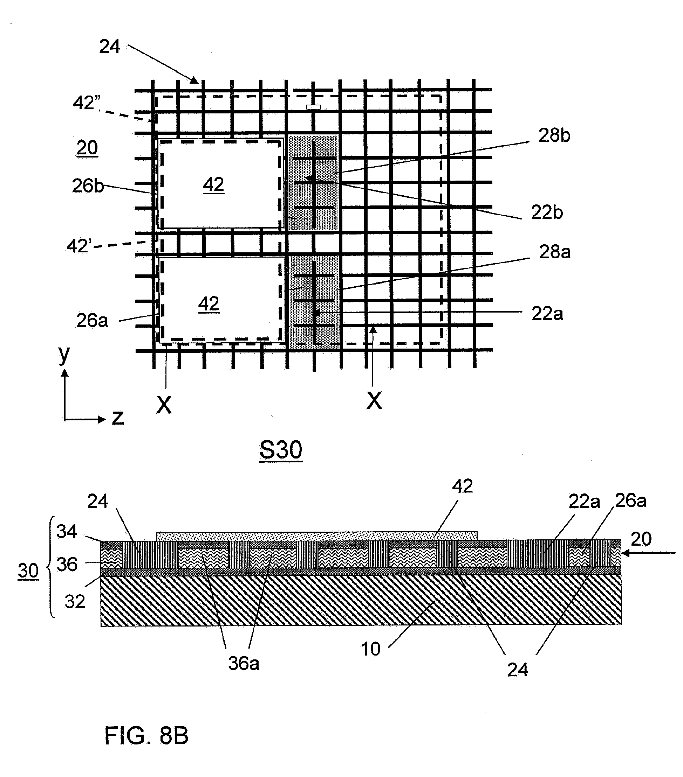

In a first step S30 as illustrated in FIG. 8B a first, translucent electrically conductive layer 42 is deposited on the foil. A plurality of layers 42 may be deposited in parallel, as is shown in FIG. 8B by way of example for two layers. The translucent electrically conductive layer 42 should cover at least an area of the mesh 24. Dependent on a first desired dimension (y) of the component to be manufactured, the deposited electrically conductive layer 42 may extend in the y-dimension along one or more enclosed zones. In this case each of the translucent electrically conductive layers 42 extends along one enclosed zone 28a, 28b respectively. In an alternative embodiment a translucent electrically conductive layer 42' would extend along two zones 28a, 28b or more, if desired. In case an electro-optic component is desired having a larger dimension in the other z-direction, the translucent electrically conductive layers 42" may also cover one or more of the enclosed electrically conductive elements 22a, 22b. In this case the translucent electrically conductive layers 42" reconnects the electrically conductive elements 22a, 22b that are formed by enclosed mesh portions 22a, 22b to the enclosing portion 24 of the (mesh-shaped) electrically conductive structure 20, and the enclosed electrically conductive elements 22a, 22b support electrical conduction for the translucent electrically conductive layers 42" within the zones 28a, 28b. By way of example it is assumed now that the translucent electrically conductive layer 42 covers an area as illustrated in FIG. 8B that does not overlap an enclosed electrically conductive element 22a, and that extends in the y-direction along one enclosed electrically conductive element 22a.

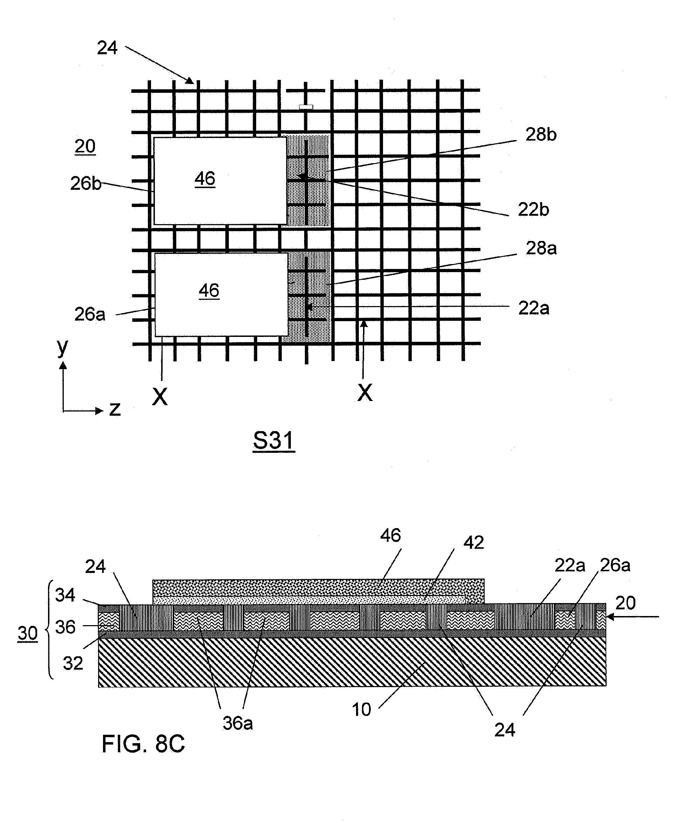

In a next step S31 as illustrated in FIG. 8C an electro-optic layer 46 is deposited over the first electrically conductive layer. It is sufficient if the electro-optic layer 46 partially covers the first electrically conductive layer. The best efficiency is obtained however if the electro-optic layer 46 fully covers the first electrically conductive layer. Furthermore, as can best be seen in the bottom part of FIG. 8C, the electro-optic layer 46 extends beyond the first translucent electrically conductive layer 42 in the direction of the at least one electrically conductive element 22a.

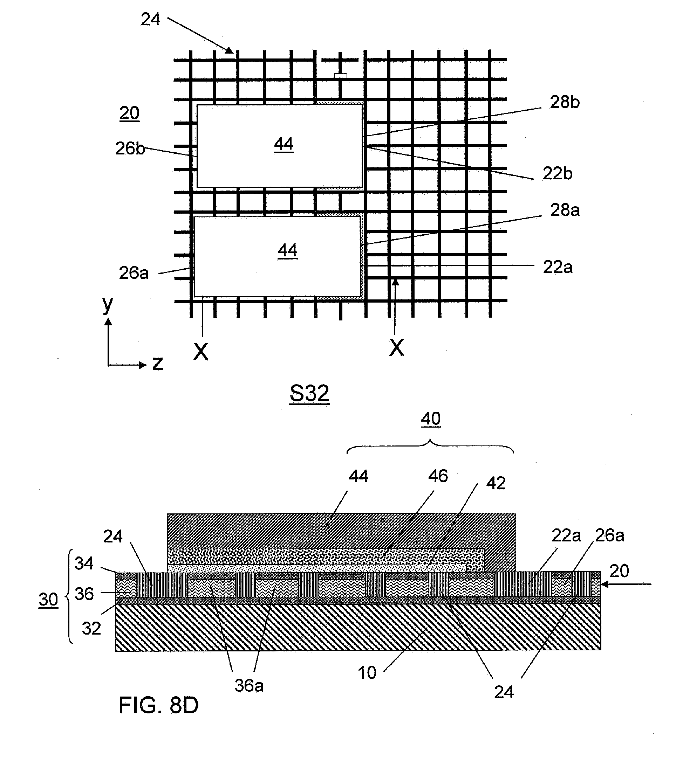

In FIG. 8D a next step S32 is shown. Therein the second electrically conductive layer 44 is deposited over the electro-optic layer 46, and over one or more insulated electrically conductive elements 22a in an enclosed zone 28a that are not in electrical contact with the first, translucent electrically conductive layer 42. The first, translucent electrically conductive layer 42, the electro-optic layer 46 and the second electrically conductive layer 44 form an electro-optic element.

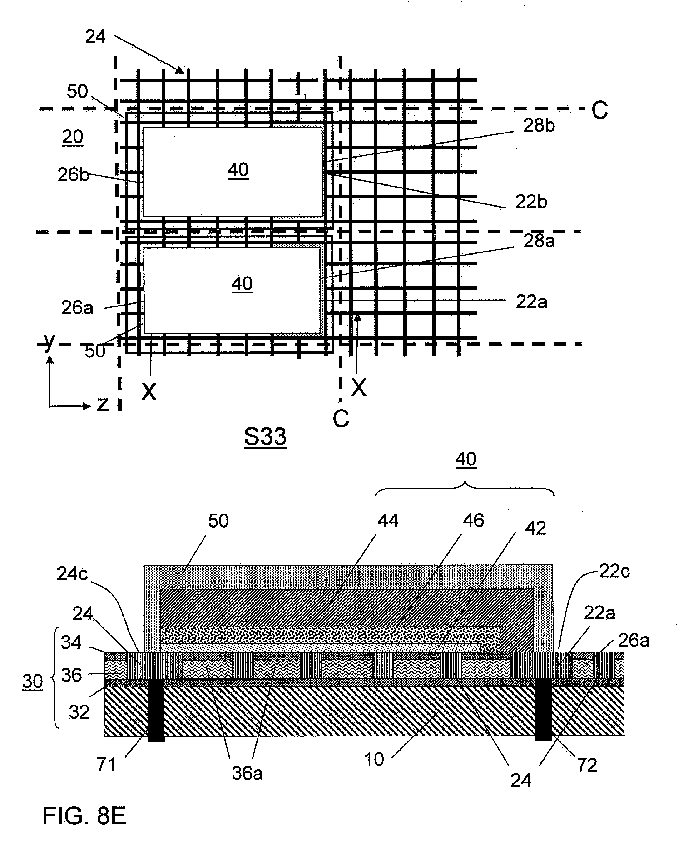

FIG. 8E shows a step S33 of providing a protection layer 50. Therein the barrier layer and the embedded electrically conductive structure in the foil encapsulate the electro-optic element. Further parts may be encapsulated together with the electro-optic element, e.g. a battery, or a getter. In FIG. 8E the protection layers 50 are applied separately for each electro-optic element 40. Alternatively, the protection layer 50 may be applied blanket wise.

The so encapsulated electro-optic elements 40 may then be separated from each other according to separation lines C.

Electric contacts 71, 72 for both electrically conductive layers 42, 44 can then formed by a feed-through element in the substrate 10. Preferably however, an exposed portion 24c of the mesh 24 and an exposed portion 22c of the electrically conductive element 22a are used as electric contacts. Feed-through elements in that case are not necessary. Due to the fact that the mesh 24 laterally encloses the separate zone, and in that a barrier surface is formed by the inorganic layer 34 and the electrically conductive structure 20, both electrodes 42 and 44 of the electro-optic element can be easily connected to an external conductor while preventing ingress of moisture or other atmospherical substances.

In the claims the word "comprising" does not exclude other elements or steps, and the indefinite article "a" or "an" does not exclude a plurality. A single component or other unit may fulfill the functions of several items recited in the claims. The mere fact that certain measures are recited in mutually different claims does not indicate that a combination of these measures cannot be used to advantage. Any reference signs in the claims should not be construed as limiting the scope.

## Claims

1. Foil comprising a substrate (10) carrying a structure (electrically conductive structure)(20) of an electrically conductive material, said electrically conductive structure (20) being embedded in a barrier layer structure (30) having a first inorganic layer (32), a second inorganic layer (34) and an organic layer (36) between said inorganic layers, said organic layer being partitioned by the electrically conductive structure into organic layer portions (36a), the electrically conductive structure comprising a mesh (24) and a plurality of mutually insulated electrically conductive elements (22a, 22b), wherein the mesh (24) laterally encloses mutually separate zones (26a, 26b) wherein respective ones of the mutually insulated electrically conductive elements (22a, 22b) are arranged.

2. Foil according to claim 1, wherein said mutually insulated electrically conductive elements (22a, 22b) have a bounding box with a smallest dimension in a range between 0.5 and 3 times the square root of the average area of openings enclosed by the mesh (24).

3. Foil according to claim 2, wherein the bounding box has a largest dimension in the range between 1.5 and 10 times its smallest dimension.

4. Foil according to claim 1, wherein the shortest distance between an insulated electrically conductive element and the enclosing mesh (24)is in the range between 1 and 5 times a width (w) of mesh elements.

5. Foil according to claim 2, wherein a plurality of mutually separate zones is arranged in a row according to the length direction of the bounding box.

6. Foil according to claim 5, wherein the bounding boxes of two subsequent mutually insulated electrically conductive elements (22a, 22b) have a mutual distance that is less than the square root of the average area of openings enclosed by the mesh (24).

7. Foil according to claim 5, wherein said row is one of a plurality of rows, and wherein the mutual distance between said rows is in the range of MIN to MAX times the square root of the average area of openings enclosed by the mesh.

8. Method of manufacturing a foil comprising a substrate (10) carrying an embedded structure (20) of an electrically conductive material, the method comprising the steps of
- providing a substrate (10),
- providing the substrate with a barrier layer structure (30) with an embedded structure (electrically conductive structure) (20) of an electrically conductive material, the barrier layer structure (30) comprising a first inorganic layer (32), a second inorganic layer (34) and an organic layer (36) between said inorganic layers, said organic layer being partitioned by the electrically conductive structure, into organic layer portions (36a), the electrically conductive structure comprising an enclosing mesh (24) and a plurality of mutually insulated electrically conductive elements (22a, 22b), wherein the enclosing mesh encloses mutually separate zones (26a, 26b) wherein respective ones of the mutually insulated electrically conductive elements (22a, 22b) are arranged.

9. Method according to claim 8, wherein the substrate is provided with the barrier layer structure (30) with the embedded mesh by the steps of
- providing (S1) a temporary carrier (TC),
- depositing (S2) the electrically conductive structure (20) on a main side of the temporary carrier (TC),
- subsequently depositing (S3, S4, S5) the second inorganic layer (34), the organic layer (36) and the first inorganic layer (32) in spaces left open by the electrically conductive structure,
- laminating (S6) the substrate (10) with the stack of layers (TC, 20, 34, 36, 32) so obtained at the side of the first inorganic layer (32),
- removing (S7) the temporary carrier (TS) from the stack of layers.

10. Method according to claim 8, wherein the substrate is provided with the barrier layer structure (30) with the embedded mesh by the steps of
- depositing (S10) the first inorganic layer over the substrate,
- applying (S11) the organic layer over the inorganic layer, the organic layer being provided (S12) with a pattern of trenches that is conformal with the pattern of the electrically conductive structure to be embedded,
- coating (S13) the patterned organic layer with the second inorganic layer over
- depositing (S14) an electrically conductive material that is to form the electrically conductive structure in the trenches in the coated organic layer.

11. Method according to claim 8, wherein the substrate (10) is provided with the barrier layer structure (30) with the embedded electrically conductive structure by the steps of
- providing (S20) a metal foil (TC) having a first surface portion (TC1) and a carrier portion (TC2),
- patterning (S21) the first surface portion (TC1) of the foil (TC) according to a pattern that is conformal with the electrically conductive structure to be formed, therewith exposing a surface of the carrier portion,
- coating (S22) the exposed surface of the carrier portion (TC2) with the second inorganic layer (34),
- depositing (S23) the organic layer over the coated first surface,
- depositing (S24) the first inorganic layer,
- laminating (S25) the substrate with the stack of layers so obtained at the side of the first inorganic layer,
- removing (S26) the carrier portion of the metal foil.

12. Electro-optic component comprising a substrate (10) carrying a structure (electrically conductive structure) (20) of an electrically conductive material, said electrically conductive structure (20) being embedded in a barrier structure (30) having a first inorganic layer (32), a second inorganic layer (34) and an organic layer (36) between said inorganic layers, said second inorganic layer and said organic layer being partitioned by the electrically conductive structure into organic layer portions (36a), the electrically conductive structure comprising an enclosing mesh (24) and at least one electrically conductive element (22a), wherein the at least one electrically conductive element (22a) is arranged in a zone (26a) that is enclosed by the enclosing mesh (24), the electro-optic component further comprising an electro-optic element (40) with a first translucent electrically conductive layer (42), a second electrically conductive layer (44) and an electro-optic layer (46) arranged between the first and the second electrically conductive layer, wherein the first translucent electrically conductive layer (42) is applied at a surface of the enclosing mesh (24) facing away from the substrate (10), and wherein the second electrically conductive layer (44) physically and electrically contacts the at least one electrically conductive element (22a) at a location laterally beyond the first translucent electrically conductive layer (42) and the electro-optic layer (46) and wherein the electro-optic component further comprises a protection layer (50) that in combination with the barrier structure encloses the electro-optic element (40).

13. Electro-optic component according to claim 12, wherein the electro-optic layer (46) extends beyond the first translucent electrically conductive layer (42) in the direction of the at least one electrically conductive element (22a).

14. Method of manufacturing an electro-optic component, the method comprising the steps of the method as claimed in claim 8, and further comprising the steps of
- depositing a first, translucent electrically conductive layer (42) on the foil,
- depositing an electro-optic layer (46) over said first electrically conductive layer,
- depositing a second electrically conductive layer (44) over said electro-optic layer, and over one or more insulated electrically conductive elements (22a) in an enclosed zone, which one or more insulated electrically conductive elements (22a) are not in electrical contact with the first, translucent electrically conductive layer (42),
the first, translucent electrically conductive layer (42), the electro-optic layer (46) and the second electrically conductive layer (44) forming an electro-optic element,
- providing a barrier layer, wherein the barrier layer and the embedded electrically conductive structure in the foil encapsulate the electro-optic element,
- separating the encapsulated electro-optic component.
